# EUROPEAN PATENT SPECIFICATION

(11) **EP 3 975 380 B1**
(45) Date of publication and mention of the grant of the patent: **28.06.2023**
(21) Application number: 21193387.4
(22) Date of filing: 26.08.2021
(51) Int. Cl.: H02J 7/00, H02H 7/18

(54) **BATTERY CONTROL DEVICE AND SHORT CIRCUIT DETECTION METHOD THEREOF**
BATTERIESTEUERUNGSVORRICHTUNG UND KURZSCHLUSSERKENNUNGSVERFAHREN DAFÜR
DISPOSITIF DE COMMANDE DE BATTERIE ET PROCÉDÉ DE DÉTECTION DE COURT-CIRCUIT ASSOCIÉ

(30) Priority: 29.09.2020 KR 20200127323
(43) Date of publication of application: 30.03.2022
(73) Proprietor: Samsung SDI Co., Ltd., Yongin-si, Gyeonggi-do 17084 (KR)
(72) Inventor: NAM, Hyungkyu, 17084 Yongin-si (KR)
(74) Representative: Marks & Clerk LLP

(56) References cited:
- EP-A1- 3 572 269
- US-A1- 2018 152 035

## Description

### BACKGROUND

### (a) Field

Embodiments of the present invention relate to a battery control device and a short-circuit detection method thereof, and more particularly, to a battery control device and a short-circuit detection method thereof that may detect a short-circuit accident caused by misconnection and the like.

### (b) Description of the Related Art

An energy storage system (ESS) installed inside a container or building is a facility that instantly charges/discharges a large amount of power. Since such an ESS is a facility that handles large-capacity power, when applying it, it is necessary to ensure safety from installation to operation. Particularly, even when a cable of a power conditioning system is misconnected due to a human error during ESS installation, various protective functions should be implemented to prevent accidents such as electric shock, short circuit, and fire.

A representative protective function may include a misconnection monitoring function. Generally, the misconnection monitoring function may be performed in the following two methods.

A first method is a method in which after installation of a facility is completed, a manager checks a resistance value of the installed cables with a resistance measuring instrument to check whether a closed circuit is formed, and then when the closed circuit is confirmed, it is determined that misconnection has occurred, so that the facility is reconstructed. In the method, there is a possibility that a human error may occur in the process of the manager checking whether there is the misconnection with the resistance measuring instrument.

A second method is a method in which a fuse is installed inside a control box to protect a battery from a short-circuit accident caused by misconnection of a cable, and when a short-circuit accident occurs due to a closed circuit formation during a system operation, the fuse blocks a short-circuit current to protect the system. In the method, various problems may occur because it is a method of determining whether a short circuit exists based on whether the fuse is blown in a state in which the system is actually operated.

For example, when a fuse blows, a lot of time and money can be consumed to find a blowing cause of blowing the fuse. The fuse may blow due to various accidents that cause short-circuit currents. However, the fuse itself has only a function of blocking the short-circuit current, and thus does not provide any function for checking the cause of the short-circuit current. The checking of the cause of the short-circuit current to eliminate the failure is performed in a way in which an operator directly checks all possible conditions for the short-circuit current to occur.

As another example, since occurrence of the short-circuit current is detected while the system is in operation, when blowing of the fuse is delayed in a short-circuit condition, the system is exposed to a high short-circuit current for a predetermined time, and thus accidents such as component damage, explosion, and insulation breakdown may occur.

As another example, in order to identify the cause of a blown fuse and restart the system, recovery costs such as a cost of replacement of materials to replace the blown fuse are required.

US 2018/152035A1 discloses a charge/discharge switch control circuit for a battery pack including a set of driving terminals and detection circuitry coupled to the driving terminals. The driving terminals provide driving signals to control a status of a switch circuit to enable charging or discharging of the battery pack. The detection circuitry receives voltages at multiple terminals of the switch circuit, and detects a status of an interface of the battery pack according to the status of the switch circuit and a difference between the voltages. For example, it is thereby possible to detect if a load connected to the interface is short-circuited or not.

The interface can receive power to charge the battery pack and provide power from the battery pack to a load.

EP3572269A1 discloses a system and method for supplying electric energy to a mining vehicle and a mining vehicle. In the presented solution electric energy is supplied to a mining vehicle using a system comprising a bipolar LVDC supply having a certain total voltage. The mining vehicle comprises at least a first energy unit and a second energy unit. The first energy unit is connected to a part of said certain total voltage and the second energy unit is connected to another part of said certain total voltage.

The above information disclosed in this Background section is only for enhancement of understanding of the background of the invention, and therefore it may contain information that does not form the prior art that is already known in this country to a person of ordinary skill in the art.

### SUMMARY

The present invention has been made in an effort to provide a battery control device and a short-circuit detection method thereof that may accurately detect whether a short circuit occurs due to misconnection or the like prior to an operation of a battery system.

The present invention is set out in the appended claims. More particularly, the present invention is directed to a first aspect corresponding to independent claim 1 and directed to a battery control device, and to a second aspect corresponding to independent claim 9 and directed to a short-circuit detection method.

In a first aspect, the present invention provides a battery control device, including: a first battery control unit connected between an external load and a first battery module and configured to control an electrical connection between the external load and the first battery module. The first battery control unit may include: a first switch electrically connected between a positive terminal of the first battery module and the external load, a second switch electrically connected between a negative terminal of the first battery module and the external load, and a first controller configured to control opening/closing of the first and second switches. The first controller may detect a short-circuit accident between the external load and the first battery control unit, according to a voltage between both ends of the first switch detected when the second switch is in a closed state and the first switch is in an opened state.

The battery control device further includes a connecting device connected between the first battery control unit and the external load. The connecting device includes a first main switch electrically connected between the first switch and a first terminal of the external load, and a second main switch electrically connected between the second switch and a second terminal of the external load.

Further, when the first main switch, the second main switch, and the first switch are in an opened state and the second switch is in a closed state, the first controller is configured to detect a short-circuit accident between the first battery control unit and the connecting device according to the voltage between both ends of the first switch.

Further, when the first main switch, the second main switch, and the second switch are in a closed state and the first switch is in an opened state, the first controller is configured to detect a short-circuit accident between the connecting device and the external load according to the voltage between both ends of the first switch.

The battery control device may further include a second battery control unit connected between a second battery module and the connecting device to control an electrical connection between the second battery module and the first and second main switches. The second battery control unit may include: a third switch electrically connected between a positive terminal of the second battery module and the first main switch, a fourth switch electrically connected between a negative terminal of the second battery module and the second main switch, and a second controller configured to control opening/closing of the third and fourth switches.

When the first main switch, the second main switch, and the third switch are in an opened state and the fourth switch is in a closed state, the second controller may detect a short-circuit accident between the second battery control unit and the connecting device according to a voltage between both ends of the third switch.

The second controller may control the third and fourth switches to be in an opened state while the first controller detects a short-circuit accident, and the first controller may control the first and second switches to be in an opened state while the second controller detects a short-circuit accident.

The battery control device may further include a main controller configured to control opening/closing of the first and second main switches. In a state in which a control signal instructing switching to a closed state is outputted to the first and second main switches, the main controller may detect an actual opening/closing state of the first and second main switches, and when the actual opening/closing state of the first main switch or the second main switch is an opened state, the main controller may determine that the first main switch or the second main switch is in a failure state.

The first controller, when both the first and second main switches are in a normal state, may detect the short-circuit accident according to the voltage between both ends of the first switch.

The main controller may open the first and second main switches when at least one of the first and second main switches is in a failure state.

The first controller, when the short-circuit accident is detected, may transmit a state signal notifying the occurrence of the short-circuit accident to the main controller, and the main controller may open the first and second main switches when the state signal notifying the occurrence of the short circuit is received.

In a second aspect, the present invention provides a short-circuit detection method of a battery control device, including: controlling a first main switch electrically connected between positive terminals of a plurality of battery modules and an external load and a second main switch electrically connected between negative terminals of the plurality of battery modules and the external load to be in a closed state; in a first battery control unit controlling an electrical connection between a first battery module among the plurality of battery modules and the first and second main switches, controlling a second switch connected between a negative terminal of the first battery module and the second main switch to be in a closed state; detecting a voltage between both ends of a first switch in an opened state of the first switch connected between a positive terminal of the first battery module and the first main switch; and detecting a first short-circuit accident between the first battery control unit and the external load according to the detected voltage between both ends of the first switch. The short-circuit detection method further includes: before the controlling of the first and second main switches to be in the closed state, maintaining the first and second main switches in an opened state; and for each of a plurality of battery control units that respectively control an electrical connection between the plurality of battery modules and the first and second main switches, detecting a second short-circuit accident between a corresponding battery control unit of the plurality of battery control units and the first and second main switches. The detecting the second short-circuit accident between the corresponding battery control unit and the first and second main switches includes: controlling a fourth switch connected between a negative terminal of a corresponding battery module of the plurality of battery modules and the second main switch to be in a closed state; detecting a voltage between both ends of a third switch in an opened state of the third switch connected between a positive terminal of the corresponding battery module and the first main switch; and detecting the second short-circuit accident between the corresponding battery control unit and the first and second main switches according to the detected voltage between both ends of the third switch.

The short-circuit detection method may further include: after controlling the first and second main switches to be in the closed state, detecting an actual opening/closing state of the first and second main switches; determining that the first main switch or the second main switch is in a failure state when the detected actual opening/closing state of the first main switch or the second main switch indicates an opened state; and when the first main switch or the second main switch is in the failure state, controlling the first and second main switches to be in an opened state.

The detecting of the voltage between both ends of the first switch and the detecting of the first short-circuit accident may be performed when the first and second main switches are in a normal state.

The short-circuit detection method may further include: when the first short-circuit accident is detected, controlling the first and second main switches to be in an opened state; and controlling the second switch to be in an opened state.

The detecting of the voltage between both ends of the first switch and the detecting of the first short-circuit accident, may be performed when the second short-circuit accident is not detected for all of the plurality of battery control units.

The first short-circuit accident may be a short-circuit accident between the first and second main switches and the external load.

According to the embodiments of the present invention, it is possible to accurately detect whether a short circuit occurs due to misconnection or the like prior to an operation of a battery system.

At least some of the above and other features of the invention are set out in the claims.

### BRIEF DESCRIPTION OF THE DRAWINGS

FIG. 1 schematically illustrates a battery system.
FIG. 2A and FIG. 2B illustrate cases in which a short-circuit accident occurs in the battery system of FIG. 1 as an example.
FIG. 3 schematically illustrates a short-circuit detection method of a battery system.
FIG. 4 schematically illustrates a battery system according to an embodiment of the present invention.
FIG. 5A and FIG. 5B illustrate cases in which a short-circuit accident occurs due to a misconnection in the battery system of FIG. 4 as an example.
FIG. 6A and FIG. 6B schematically illustrate a short-circuit detection method of a battery system according to an embodiment of the present invention.

### DETAILED DESCRIPTION OF THE EMBODIMENTS

Embodiments of the present invention will now be described in detail with accompanying drawings. Effects and characteristics of embodiments, and a realization method thereof will now be described in detail with accompanying drawings. In the drawings, same reference numerals indicate same constituent elements, and no repeated descriptions thereof will be provided. As those skilled in the art would realize, the described embodiments may be modified in various different ways, all without departing from the scope of the present invention if they do not contradict the claims (i.e. if they comprise all features of at least one of the independent claims).

The embodiments are provided as examples so that the present disclosure may be thorough and complete, and will sufficiently supply aspects and characteristics of the present invention to a person skilled in the art.

Hence, for the purpose of complete understanding on the aspects and the characteristics of the present invention, processes, factors, and skills that may not be needed by a person of ordinary skill in the art may not be described. In the drawings, relative sizes of elements, layers, and regions may be exaggerated for clarity.

In the present specification, the term "and/or" includes all or random combinations of a plurality of items that are related and arranged. When the embodiments of the present invention are described, the use of "may" signifies "at least one embodiment of the present invention". Regarding the description on an embodiment of the present invention, a singular term may include a plural form unless stated in another way.

Terms including ordinal numbers such as first, second, and the like will be used only to describe various components, and are not to be interpreted as limiting these components. The terms are only used to differentiate one component from other components. For example, a first constituent element could be termed a second constituent element, and similarly, a second constituent element could be termed a first constituent element, without departing from the scope of the present invention.

Electrically connecting two constituent elements includes directly connecting two constituent elements and connecting the same with another constituent element therebetween. The other constituent element may include a switch, a resistor, and a capacitor. When the embodiments are described, an expression of connection signifies electrical connection when an expression of direct connection is not provided.

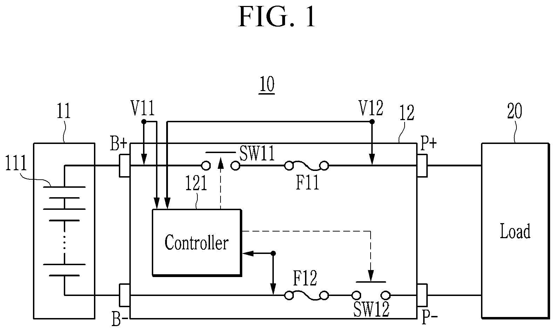

FIG. 1 schematically illustrates a battery system.

Referring to FIG. 1, a battery system 10 may include a battery module 11 and a battery control device 12.

The battery module 11 may include a plurality of battery cells 111 electrically connected to each other in series or in parallel.

The battery control device 12 may detect state information such as a voltage, a current, and a temperature of the battery module 11, and may control a connection between the battery module 11 and an external device (a load 20 or a charging device (not shown)) based on the state information. To this end, the battery control device 12 may include a plurality of switches SW11 and SW12 and a controller 121.

The switches SW11 and SW12 may be respectively connected between system terminals P+ and P- that are electrically connected to the load 20 or the charging device and both terminals B+ and B- of the battery module 11 to electrically connect the battery module 11 and the system terminals P+ and P- or to block an electrical connection between them. For example, the switch SW11 may be electrically connected between a positive terminal B+ of the battery module 11 and the system terminal P+, and the switch SW12 may be connected between a negative terminal B- of the battery module 11 and the system terminal P-. These switches SW11 and SW12 may be relays, contactors, or the like. In addition, the switches SW11 and SW12 may also be a field effect switch (FET), a solid state switch (SSS), or the like.

In order to monitor a state of the battery module 11, the controller 121 may acquire state information such as a voltage, a current, and a temperature related to the state of the battery module 11. In addition, the controller 121 detects an overcharge or over-discharge state of the battery module 11 based on the state information of the battery module 11, and it may control opening/closing (or conductivity) of the switches SW11 and SW12 based on the detected overcharge or over-discharge result.

In addition, a function of detecting a short circuit between the controller 121 and the system terminals P+ and P- may be performed. In this case, the short-circuit condition to be detected by the controller 121 is due to an abnormal short-circuit accident, which may be distinguished from a normal short-circuit condition. The controller 121 may detect voltages V11 and V12 at respective ends of the switch SW11 when the switch SW12 is in a closed state (or conductive state) and the switch SW11 is in an opened state (or nonconductive state). In addition, when the voltages V11 and V12 at respective ends of the switch SW11 calculated therefrom are greater than 0 V, the controller 121 may determine that a short circuit has occurred between the system terminals P+ and P-.

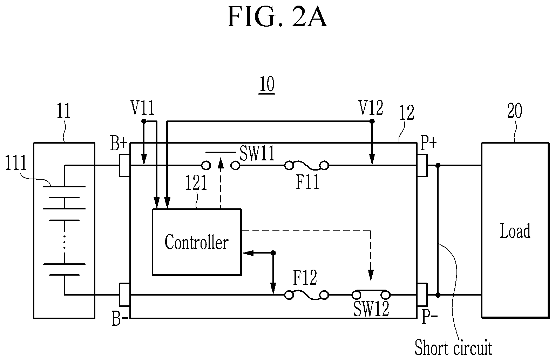

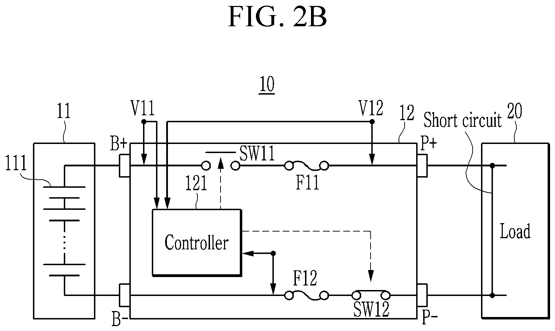

FIG. 2Aand FIG. 2B illustrate cases in which a short circuit occurs outside the battery system 10, that is, between the system terminals P+ and P-. FIG. 2A illustrates a case in which the system terminals P+ and P- are short-circuited with each other due to the misconnection between the system terminals P+ and P- and the load 20, and the presence of a short circuit between the system terminals P+ and P-, as an example. FIG. 2B illustrates an example in which the system terminals P+ and P- are short-circuited with each other due to a short circuit inside the load 20. Referring to FIG. 2A and FIG. 2B, when the switch SW12 is closed while the system terminals P+ and P- are shorted to each other, the system terminal P+ is electrically connected to the negative terminal of the battery module 11. Accordingly, one end of the switch SW11 is connected to the positive terminal of the battery module 11, and the other end of the switch SW11 is connected to the negative terminal of the battery module 11, so that a voltage between both ends of the switch SW11 may be an output voltage of the battery module 11, that is, a voltage greater than 0 V.

On the other hand, when the switch SW12 is closed in a state in which the system terminals P+ and P- are not shorted to each other, the system terminal P+ is in a floating state, whereby one end of the switch SW11 is connected to the positive terminal of the battery module 11 and the other end of the switch SW11 is in a floating state. In this state, a voltage measuring circuit (not shown) inside the controller 121 may detect the voltage between both ends of the switch SW11 as 0 V, or determine that the voltage between both ends of the switch SW11 is in an unmeasurable state. Accordingly, in the state in which the switch SW12 is closed in order to detect a short circuit, when the voltage between both ends of the switch SW11 in the opened state is detected as 0 V or is detected as unmeasurable, the controller 121 may determine a normal state in which a short circuit between the system terminals P+ and P- does not occur.

The controller 121 performs the above-described short-circuit state detection function before an operation of the battery system 10, and when a short circuit is detected through this, the controller 121 may control the switches SW11 and SW12 in an opened state to output a failure alarm, or may transmit a state signal warning of this to an upper system (not shown). On the other hand, when no short-circuit state is detected, the controller 121 determines that a normal operation of the battery system 10 is possible and allows the switches SW11 and SW12 to be closed.

The battery control device 12 may further include at least one fuse to protect the battery module 11 from an overcurrent. Referring to FIG. 1 as an example, the battery control device 12 may further include a fuse F11 connected between the positive terminal of the battery module 11 and the system terminal P+, and a fuse F12 connected between the negative terminal of the battery module 11 and the system terminal P-.

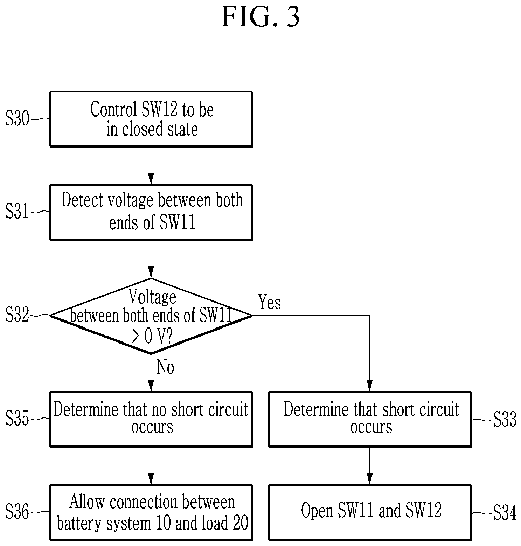

FIG. 3 schematically illustrates a short-circuit detection method of a battery system. The method of FIG. 3 may be performed by the battery control device 12 of the battery system 10 described with reference to FIG. 1.

Referring to FIG. 3, the battery control device 12, before operating the battery system 10, controls the switch SW12 to be in the closed state through the controller 121 to detect a short-circuit condition of the system terminals P+ and P-, that is, a short-circuit condition outside the battery system 10 (S30). Since the switches SW11 and SW12 are in an opened state before starting of the battery system 10, when the switch SW12 is closed, the switch SW11 maintains an opened state. In this state, the controller 121 of the battery control device 12 detects the voltage between both ends of the switch SW11 in the opened state (S31).

When the voltage between both ends of the switch SW11 detected through step S31 is greater than 0 V (S32), the controller 121 determines that a short circuit occurs outside of the battery system 10, that is, that the system terminals P+ and P- are shorted to each other to form a closed circuit (S33).

As the short-circuit condition is detected, the controller 121 controls both switches SW11 and SW12 to be in the opened state (S34). In addition, the controller 121 may output a failure alarm or transmit a state signal warning that a short circuit has occurred, to the upper system.

Meanwhile, when the voltage between both ends of the switch SW11 in step S32 is not greater than 0 V, that is, when it is 0 V or an unmeasurable state, the controller 121 determines that a short circuit has not occurred between the system terminals P+ and P- of the battery system 10 (S35). When it is determined that the short circuit has not occurred, the controller 121 determines that the normal operation of the battery system 10 is possible and allows the connection between the battery system 10 and the load 20 (S36). That is, the switches SW11 and SW12 are allowed to be switched to be in the closed state.

Meanwhile, in the above-described system, the battery system 10 including one battery module 11 is illustrated as an example, but the main technical features thereof are applicable even when the battery system 10 includes a plurality of battery modules.

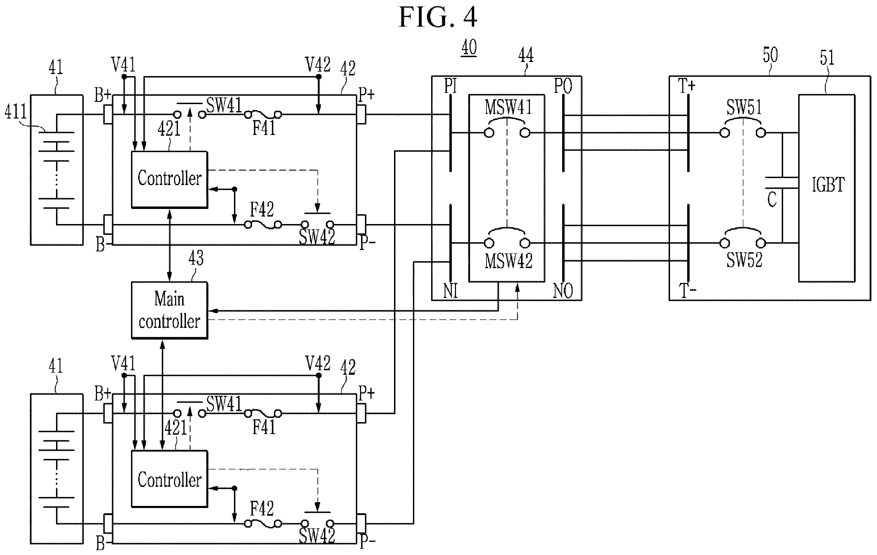

FIG. 4 schematically illustrates a battery system according to an embodiment of the present invention, wherein the battery system includes a plurality of battery modules that are connected to each other in parallel. In FIG. 4, a battery system 40 may correspond to an energy storage system (ESS), and a load 50 connected to the battery system 40 may correspond to a power conditioning system (PCS). The power conditioning system 50 is a system that converts DC power supplied from the energy storage system 40 into AC power to supply it to power consumers, and it may include a plurality of switches SW51 and SW52, a smoothing capacitor C, and an insulating gate bipolar transistor (IGBT) 51.

Referring to FIG. 4, the battery system 40 according to another embodiment of the present invention may include a plurality of battery modules 41, and a battery control device for controlling connection between the plurality of battery modules 41 and the load 50. The battery control device may include a plurality of battery control units 42 each connected to the plurality of battery modules 41 to control connection for each battery module 41, a main controller 43, and a connecting device 44 connected between the plurality of battery control units 42 and the load 50 to control connection between the battery system 40 and the load 50.

The battery module 41 may include a plurality of battery cells 411 electrically connected to each other in series or in parallel.

The battery control unit 42 may detect state information such as a voltage, a current, and a temperature of the corresponding battery module 41, and may control the connection between the corresponding battery module 41 and the connecting device 44 based on this. To this end, the battery control unit 42 may include a plurality of switches SW41 and SW42 and a controller 421.

The switches SW41 and SW42 may be respectively connected between the system terminals P+ and P- and both terminals B+ and B- of the battery module 41 to electrically connect the battery module 41 and the system terminals P+ and P- or to block an electrical connection between them. For example, the switch SW41 may be electrically connected between a positive terminal B+ of the battery module 41 and the system terminal P+, and the switch SW42 may be connected between a negative terminal B- of the battery module 41 and the system terminal P-. These switches SW41 and SW42 may be relays, contactors, or the like. In addition, the switches SW41 and SW42 may be FETs, SSSs, or the like.

In order to monitor a state of the battery module 41, the controller 421 may acquire state information such as a voltage, a current, and a temperature related to the state of the battery module 41. In addition, the controller 421 detects a overcharge or over-discharge state of the battery module 41 based on the state information of the battery module 41, and it may control opening/closing of the switches SW41 and SW42 based on the detected overcharge or over-discharge result.

Each battery control unit 42 may further include at least one fuse to protect the corresponding battery module 41 from an overcurrent. Referring to FIG. 4 as an example, each battery control unit 42 may further include a fuse F41 connected between the positive terminal B+ of the corresponding battery module 41 and the system terminal P+, and a fuse F42 connected between the negative terminal B- of the corresponding battery module 41 and the system terminal P-.

The connecting device 44 may be disposed between the plurality of battery control units 42 and the load 50 to block or allow the connection between the plurality of battery control units 42 and the load 50. To this end, the connecting device 44 may include a plurality of input terminals PI and NI, a plurality of output terminals PO and NO, and a plurality of main switches MSW41 and MSW42 each connected between the plurality of input terminals PI and NI and the plurality of output terminals PO and NO.

The system terminals P+ of the battery control units 42 may be electrically connected to the positive input terminal PI, and the system terminals P- of the battery control units 42 may be electrically connected to the negative input terminal NI. The positive output terminal PO may be electrically connected to a positive connector T+ of the load 50, and the negative output terminal NO may be electrically connected to a negative connector T- of the load 50. The connecting device 44 is a connecting device for configuring an electrical connection between equipment (e.g. the battery control unit 42 and the load 50) with a homopolar multi-line, and wires connected to respective input terminals PI and NI and respective output terminals PO and NO are electrically combined to each other by a corresponding connector. Accordingly, the plurality of battery modules 41 may be connected in parallel to each other by the connecting device 44.

The main switch MSW41 may be connected between the positive input terminal PI and the positive output terminal PO to electrically connect the positive input terminal PI and the positive output terminal PO or to block the connection between them. The main switch MSW42 may be connected between the negative input terminal NI and the negative output terminal NO to electrically connect the negative input terminal NI and the negative output terminal NO or to block the connection between them. Opening/closing (or conductivity) of these main switches MSW41 and MSW42 may be controlled by a control signal inputted from the main controller 43.

The main controller 43 may control the opening/closing of main switches MSW41 and MSW42 included in the connecting device 44 to control the connection between the battery control units 42 and the load 50. That is, the main controller 43 may control the supply of power from the battery system 40 to the load 50 by controlling the connection between the battery system 40 and the load 50 by controlling the opening/closing of the main switches MSW41 and MSW42.

The main controller 43 may detect an actual opening/closing state of the main switches MSW41 and MSW42. The main controller 43 may compare the control signals outputted by the main controller 43 to the main switches MSW41 and MSW42 with the actual opening/closing states of the corresponding main switches MSW41 and MSW42 to detect whether the main switches MSW41 and MSW42 are in a failure state. That is, when the opening/closing state indicated by the control signal outputted to the main switches MSW41 and MSW42 is different from the actual opening/closing state of the main switches MSW41 and MSW42, the main controller 43 may determine that the main switches MSW41 and MSW42 are in a failure state.

The main controller 43 may communicate with the controller 421 of each battery control unit 42. The main controller 43 may receive the state information of the corresponding battery module 41 or the opening/closing state information of the corresponding switches SW41 and SW42 from the controller 421 of each battery control unit 42 through communication. In addition, the main controller 43 may transmit the opening/closing state information of the main switches MSW41 and MSW42 to the controller 421 of each battery control unit 42.

Meanwhile, the battery control unit 42 may perform a function of detecting a short-circuit state between the system terminals P+ and P- due to misconnection or the like in a similar manner to the battery control device 12 of FIG. 1. Even in this embodiment, the short-circuit state detected by the battery control unit 42 is due to an abnormal short-circuit accident, and may be distinguished from a normal short-circuit state. When the switch SW42 is in the closed state (or conducting state) and the switch SW41 is in the opened state (or non-conducting state), voltages V41 and V42 at both ends of the switch SW41 are detected, and the detected voltages V41 and V42 at both ends of the switch SW41 are greater than 0 V, the controller 421 may determine that a short circuit has occurred between the system terminals P+ and P-.

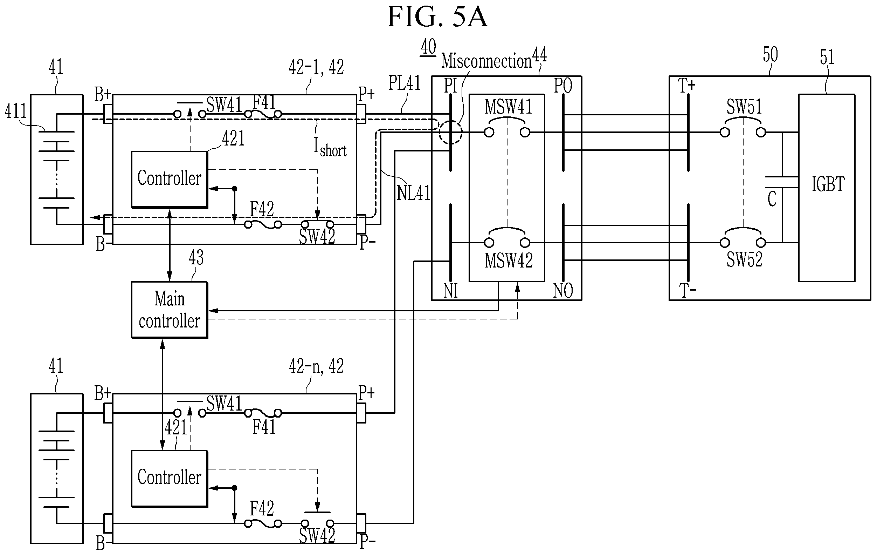

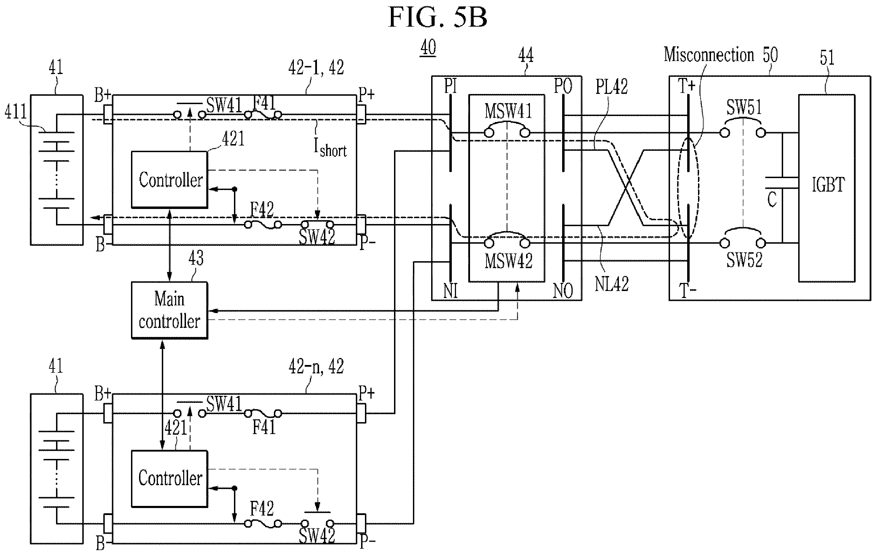

FIG. 5A and FIG. 5B illustrate cases in which a short circuit occurs between the system terminals P+ and P- due to misconnection in the battery system 40 of FIG. 4. FIG. 5A illustrates a case in which the system terminals P+ and P- are short-circuited to each other due to misconnection at the level of the battery control unit 42, that is, misconnection between the battery control unit 42 and the connecting device 44. FIG. 5B illustrates a case in which the system terminals P+ and P- are short-circuited to each other due to misconnection at the level of the battery system 40, that is, misconnection between the connecting device 44 and the load 50.

Referring to FIG. 5A, a wire NL41 between a system terminal P- of a battery control unit 42-1 and the connecting device 44 is misconnected, and thereby the system terminals P+ and P- of the battery control unit 42-1 are all connected to the positive input terminal PI of the connecting device 44. Accordingly, when the system terminals P+ and P- of the battery control unit 42-1 are shorted to each other and the switches SW41 and SW42 of the battery control unit 42-1 are closed, a short-circuit current Iₛₕₒᵣₜ occurs.

Referring to FIG. 5B, one PL42 of the wires connected to the positive output terminal PO of the connecting device 44 is misconnected to the negative connector T- instead of the positive connector T+ of the load 50, and one NL42 of the wires connected to the negative output terminal NO is misconnected to the positive connector T+ of the load 50. Accordingly, when the output terminals PO and NO of the connecting device 44 are short-circuited to each other such that the switches SW41 and SW42 of the battery control unit 42 and the main switches MSW41 and MSW42 are closed, the short-circuit current Iₛₕₒᵣₜ occurs.

As shown in FIG. 5A, when a short circuit occurs between the battery control unit 42-1 and the connecting device 44 due to misconnection and the like, the corresponding battery control unit 42-1 may detect the occurrence of a short circuit by performing the above-described short-circuit detection function regardless of the opening/closing state of the main switches MSW41 and MSW42. That is, the controller 421 of the corresponding battery control unit 42-1 may measure the voltages V41 and V42 at both ends of the switch SW41 in the opened state from the closed state of the switch SW42, thereby detecting occurrence of a short circuit between the system terminals P+ and P-.

As shown in FIG. 5B, when a short circuit occurs between the connecting device 44 and the load 50 due to misconnection, the battery control unit 42 may detect the occurrence of the short circuit by performing the above-described short-circuit detection function only when all of the main switches MSW41 and MSW42 of the connecting device 44 are closed. That is, the controller 421 of the battery control unit 42 controls the switch SW42 to be in the closed state while the main switches MSW41 and MSW42 are all closed, and in this state, it may detect a short circuit between the system terminals P+ and P- by measuring the voltages V41 and V42 at both ends of the switch SW41 of the opened state.

Accordingly, in this embodiment, in order to distinguish whether the short circuit occurs between the battery control unit 42 and the connecting device 44 or between the connecting device 44 and the load 50, by sequentially performing the short-circuit state detection function for each battery control unit 42 in the opened state of all the main switches MSW41 and MSW42, whether the connection state between, that is, the short circuit occurrence between the battery control units 42 and the connecting device 44, is first checked. In addition, after confirming that all the connection states between the battery control units 42 and the connecting device 44 are normal, both the main switches MSW41 and MSW42 are closed, and in this state, the connection state between the connecting device 44 and the load 50 may be checked by performing the above-described short-circuit detection function in one of the battery control units 42.

The battery control units 42 perform the above-described short-circuit state detection function before an operation of the battery system 40, and when a short circuit is detected through this, they may control the switches SW41 and SW42 in an opened state to transmit a state signal warning of this to the main controller 43. On the other hand, when no short-circuit state is detected, the battery control units 42 determine that a normal operation of the battery system 40 is possible and allow the switches SW41 and SW42 to be closed. In addition, a state signal notifying that the connection between the battery control unit 42 and the connecting device 44 and the connection between the connecting device 44 and the load 50 are in a normal state may be transmitted to the main controller 43.

When the main controller 43 receives a state signal indicating the occurrence of a short circuit from the at least one battery control unit 42, the main controller 43 may separate the battery system 40 from the load 50 by controlling the main switches MSW41 and MSW42 to be in an opened state. In addition, the main controller 43 may output a failure alarm or notify the failure occurrence to a higher-level system (not shown) or an administrator terminal (not shown). On the other hand, when the state signals indicating that the states of the connections between all the battery control units 42 and the connecting device 44 and of the connection between the connecting device 44 and the load 50 are normal are received, the main controller 43 determines that the normal operation of the battery system 40 is possible and allows closing of the main switches MSW41 and MSW42.

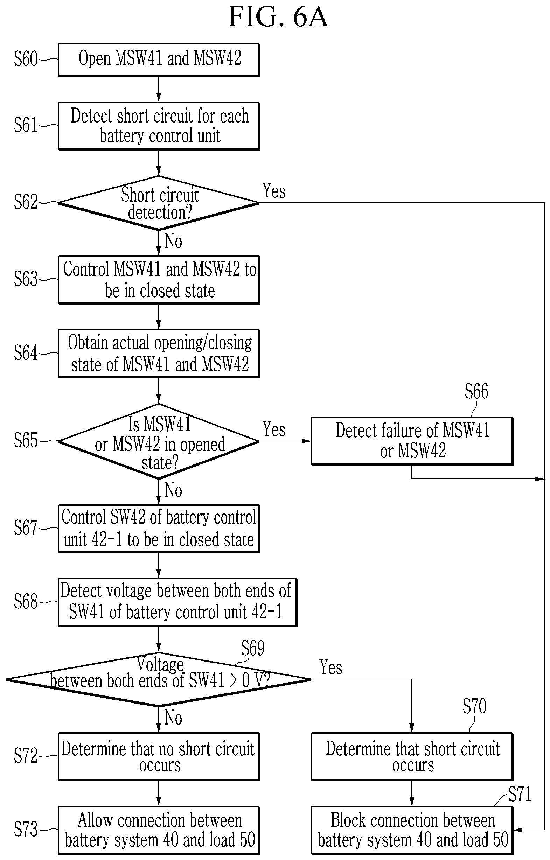

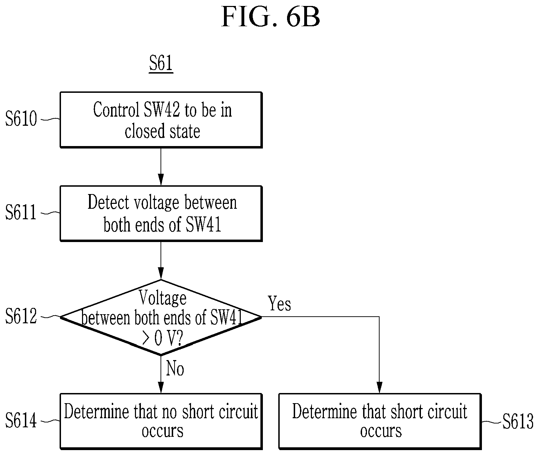

FIG. 6A and FIG. 6B schematically illustrate a short-circuit detection method of a battery system according to an embodiment of the present invention. The method of FIG. 6A and FIG. 6B may be performed by the battery control device of the battery system 40 described with reference to FIG. 4.

Referring to FIG. 6A, in order to detect a short circuit in a level of the battery control unit 42 before an operation of the battery system 40, the battery control device maintains the main switches MSW41 and MSW42 in an opened state (S60), and in this state, it sequentially performs short-circuit detection for each battery control unit 42 (S61).

FIG. 6B specifically illustrates a method of performing the short-circuit detection at the level of the battery control unit 42 in each battery control unit 42 in step S61.

Referring to FIG. 6B, the controller 421 of each battery control unit 42 controls the switch SW42 to be in a closed state in order to detect occurrence of a short circuit between the battery control unit 42 and the connecting device 44 (S610). In this case, the switch SW41 of the corresponding battery control unit 42 maintains an opened state, and the controller 421 detects a voltage between both ends of the switch SW41 in the opened state (S611).

When the voltage between both ends of the switch SW41 detected through step S611 is greater than 0 V (S612), the controller 421 determines that since a short circuit occurs between the corresponding battery control unit 42 and the connecting device 44 to form a closed circuit, the system terminals P+ and Pare shorted to each other (S613). As the short circuit is detected, the controller 421 may transmit a state signal indicating that the short circuit has occurred between the corresponding battery control unit 42 and the connecting device 44 to the main controller 43.

Meanwhile, when the voltage between both ends of the switch SW41 in step S612 is not greater than 0 V, that is, when it is 0 V or an unmeasurable state, the controller 421 determines that no short circuit occurs between the corresponding battery control unit 42 and the connecting device (S614). When it is determined that no short circuit occurs, the controller 421 may transmit a state signal indicating that the connection between the corresponding battery control unit 42 and the connecting device 44 is in a normal state to the main controller 43.

Each battery control unit 42 may detect occurrence of a short circuit between the corresponding battery control unit 42 and the connecting device 44 by performing step S610 to step S613 described above. On the other hand, while one battery control unit 42 is performing the method to detect the short circuit through steps S601 to step S613 described above, the remaining battery control units 42 remain disconnected from the connecting device 44 in order to not affect the detection result (that is, the switches SW41 and SW42 are opened in the remaining battery control units 42).

Referring back to FIG. 6A, when the occurrence of a short circuit between each battery control unit 42 and the connecting device 44 is not detected in step S61 described above (S62), in order to detect the occurrence of a short circuit in the battery system 40, that is, the occurrence of a short circuit between the connecting device 44 and the load 50, the main controller 43 controls the main switches MSW41 and MSW42 to be in a closed state (S63). That is, control signals instructing switching to a closed state are outputted to the main switches MSW41 and MSW42.

In this state, the main controller 43 obtains an actual opening/closing state of the main switches MSW41 and MSW42 from the connecting device 44 (S64), and based on this, it first determines whether the main switches MSW41 and MSW42 are in a failure state. That is, in the state in which the control signals instructing the switching of the closed state are outputted to the main switches MSW41 and MSW42, when the detected actual opening/closing state of the main switches MSW41 and MSW42 indicates that the main switch MSW41 or the main switch MSW42 is in an opened state (S65), the main controller 43 detects that the main switch MSW41 or the main switch MSW42 is in a failure state (S66). On the other hand, when both the main switches MSW41 and MSW42 are in the closed state (S65), it is determined that both main switches MSW41 and MSW42 are normally operating, and a process of detecting the short circuit between the connecting device 44 and the load 50 is performed.

That is, the main controller 43 instructs the controller 421 of one (for example, the battery control unit 42-1 of FIG. 5B) of the battery control units 42 to detect a short circuit, and the controller 421 receiving this controls the corresponding switch SW42 to be in a closed state (S67). In this case, the switch SW41 of the corresponding battery control unit 42-1 maintains an opened state, and the controller 421 detects a voltage between both ends of the switch SW41 of the opened state (S68).

When the voltage between both ends of the switch SW41 detected through step S68 is greater than 0 V (S69), the controller 421 determines that since a short circuit occurs between the corresponding connecting device 44 and the load 50 to form a closed circuit, the system terminals P+ and P- are shorted to each other (S70). Meanwhile, when the voltage between both ends of the switch SW41 in step S69 is not greater than 0 V, that is, when it is 0 V or an unmeasurable state, the controller 421 determines that a short circuit does not occur between the connecting device 44 and the load 50 (S72).

When the short circuit is detected between the at least one battery control unit 42 and the connecting device 44 through the above-described step S62, when the failure of at least one of the main switches MSW41 and MSW42 is detected in the above-described step S65, or when the short circuit between the connecting device 44 and the load 50 is detected through the above-described step S69, the main controller 43 determines that the normal operation of the battery system 40 is difficult. Accordingly, the main controller 43 instructs each controller 421 to release the connection between each battery control unit 42 and the connecting device 44, that is, to open the switches SW41 and SW42, and it blocks the connection between the battery system 40 and the load 50 by opening the main switches MSW41 and MSW42 (S71).

On the other hand, when no short circuit or failure of the main switches MSW41 and MSW42 is detected, the main controller 43 instructs each controller 421 to allow the closed state of the switches SW41 and SW42, and allows the connection between the battery system 40 and the load 50 by allowing the closed state of the main switches MSW41 and MSW42 (S73).

According to the above-described embodiments, before the battery systems 10 and 40 are operated as the power source of the loads 20 and 50, the short-circuit state caused by misconnection inside or outside the battery systems 10 and 40 may be detected. Therefore, it is possible to detect the short-circuit state and take appropriate measures before the components of the battery systems 10 and 40 are damaged due to the short-circuit current, thereby preventing the damage of the components and consequent replacement costs, and increasing the lifespan of the battery systems 10 and 40. In addition, such a short-circuit detection procedure is automatically performed by the battery systems 10 and 40, so that human errors due to inexperience of the administrator may be avoided, and the detection time may be shortened, thereby further improving safety and efficiency of the system.

Electronic or electrical devices according to embodiments of the present invention and/or other related devices or constituent elements may be realized by using appropriate hardware, firmware (e.g., an application-specific integrated circuit), software, or combinations of software, firmware, and hardware. For example, various configurations of the above-noted devices may be positioned on one or more integrated circuit (IC) chip or an individual IC chip. In addition, various configurations of the above-noted devices may be realized on a flexible printed circuit film, a tape carrier package (TCP), a printed circuit board (PCB), or one substrate. The electrical or mutual connections described in the present specification may, for example, be realized by the PCB, wires or different types of circuit carriers, or conductive elements. The conductive elements may, for example, include metallization such as surface metallizations and/or pins, and may include conductive polymers or ceramics. Further, electrical energy may be transmitted by electromagnetic radiation or a light-using radio access.

In addition, the various configurations of the devices may be performed by at least one processor so as to perform the above-described various functions, they may be performed in at least one computing device, and they may be processes or threads for performing computer program instructions and interacting with other system constituent elements. The computer program instruction is stored in a memory realizable in a computing device using a standard memory device such as a random access memory (RAM). The computer program instruction may also be stored in a non-transitory computer readable medium such as a CD-ROM or a flash drive.

Further, a person of ordinary skill in the art must understand that various functions of the computing device may be combined or united to a single computing device, or functions of a specific computing device may be dispersed to at least another computing device, while not digressing from the range of the embodiments of the present invention.

### <Description of symbols>

10, 40: battery systems
11, 41: battery modules
111, 411: battery cells
12: battery control device
121: controller
20, 50: loads
42, 42-1: battery control units
421: controller
43: main controller
44: connecting device
F11, F12, F41, F42: fuses
SW11, SW12, SW41, SW42: switches
MSW41, MSW42: main switches
P+, P-: system terminals
PI, NI: input terminals of connecting device
PO, NO: output terminals of connecting device

## Claims

1. A battery control device, comprising:
a first battery control unit (12; 42) connectable between an external load (20; 50) and a first battery module (11; 41) and configured to control an electrical connection between the external load (20; 50) and the first battery module (11; 41),
wherein the first battery control unit (12; 42) includes:
a first switch (SW11; SW41) electrically connectable between a positive terminal (B+) of the first battery module (11; 41) and the external load (20; 50),
a second switch (SW12; SW42) electrically connectable between a negative terminal (B-) of the first battery module (11; 41) and the external load (20; 50), and
a first controller (121; 421) configured to control opening/closing of the first and second switches (SW11; SW12; SW41; SW42), and
wherein the first controller (121; 421) is configured to detect a short-circuit accident between the external load (20; 50) and the first battery control unit (12; 42), according to a voltage between both ends of the first switch (SW11; SW41) detected when the second switch (SW12; SW42) is in a closed state and the first switch (SW11; SW41) is in an opened state;
further comprising
a connecting device (44) connectable between the first battery control unit (12; 42) and the external load (20; 50),
wherein the connecting device (44) includes
a first main switch (MSW41) electrically connectable between the first switch (SW11; SW41) and a first terminal (T+) of the external load (20; 50), and
a second main switch (MSW42) electrically connectable between the second switch and a second terminal (T-) of the external load (20; 50);
wherein
when the first main switch (MSW41), the second main switch (MSW42), and the first switch (SW11; SW41) are in an opened state and the second switch (SW12; SW42) is in a closed state, the first controller (121; 421) is configured to detect the short-circuit accident between the first battery control unit (12; 42) and the connecting device (44) according to the voltage between both ends of the first switch (SW11; SW41); and
when the first main switch (MSW41), the second main switch (MSW42), and the second switch (SW12; SW42) are in a closed state and the first switch (SW11; SW41) is in an opened state, the first controller (121; 421) is configured to detect a short-circuit accident between the connecting device (44) and the external load (20; 50) according to the voltage between both ends of the first switch (SW11; SW41).

2. The battery control device of claim 1, further comprising
a second battery control unit (42-n) connectable between a second battery module (41) and the connecting device (44) and configured to control an electrical connection between the second battery module (41) and the first and second main switches (MSW41; MSW42),
wherein the second battery control unit (42-n) includes:
a third switch (SW41) electrically connectable between a positive terminal (B+) of the second battery module (41) and the first main switch (MSW41),
a fourth switch (SW42) electrically connectable between a negative terminal (B-) of the second battery module (41) and the second main switch (MSW42), and
a second controller (421) configured to control opening/closing of the third and fourth switches (SW41; SW42).

3. The battery control device of claim 2, wherein
when the first main switch (MSW41), the second main switch (MSW42), and the third switch (SW41) are in an opened state and the fourth switch (SW42) is in a closed state, the second controller (421) is configured to detect a short-circuit accident between the second battery control unit (42-n) and the connecting device (44) according to a voltage between both ends of the third switch (SW41).

4. The battery control device of claim 3, wherein
the second controller (421) is configured to control the third and fourth switches (SW41; SW42) to be in an opened state while the first controller (421) detects a short-circuit accident, and
the first controller (421) is configured to control the first and second switches (SW41; SW42) to be in an opened state while the second controller (421) detects a short-circuit accident.

5. The battery control device of claim 1, further comprising
a main controller (43) configured to control opening/closing of the first and second main switches (MSW41; MSW42),
wherein the main controller (43) is configured to:
detect an actual opening/closing state of the first and second main switches (SW41; SW42) in a state in which a control signal instructing switching to a closed state is outputted to the first and second main switches (SW41; SW42); and
determine that the first main switch (MSW41) or the second main switch (MSW42) is in a failure state when the actual opening/closing state of the first main switch (MSW41) or the second main switch (MSW42) is an opened state.

6. The battery control device of claim 5, wherein
the first controller (421) is configured to detect the short-circuit accident according to the voltage between both ends of the first switch (SW41) when both the first and second main switches (MSW41; MSW42) are in a normal state.

7. The battery control device of claim 5 or 6, wherein
the main controller (43) is configured to open the first and second main switches (MSW41; MSW42) when at least one of the first and second main switches (MSW41; MSW42) is in the failure state.

8. The battery control device of any of claims 5 to 7, wherein
the first controller (421) is configured to transmit a state signal notifying the occurrence of the short-circuit accident to the main controller (43) when the short-circuit accident is detected, and
the main controller (43) is configured to open the first and second main switches (MSW41; MSW42) when the state signal notifying the occurrence of the short circuit is received.

9. A short-circuit detection method of a battery control device, comprising:
controlling a first main switch (MSW41) electrically connected between positive terminals (B+) of a plurality of battery modules (41) and an external load (50) and a second main switch (MSW42) electrically connected between negative terminals (B-) of the plurality of battery modules (41) and the external load (50) to be in a closed state;
in a first battery control unit (42-n) controlling an electrical connection between a first battery module (41) among the plurality of battery modules (41) and the first and second main switches (MSW41; MSW42), controlling a second switch (SW42) connected between a negative terminal (B-) of the first battery module (41) and the second main switch (MSW42) to be in a closed state;
detecting a voltage between both ends of a first switch (SW41) in an opened state of the first switch (SW41) connected between a positive terminal (B+) of the first battery module (41) and the first main switch (MSW41); and
detecting a first short-circuit accident between the first battery control unit (42-n) and the external load (50) according to the detected voltage between both ends of the first switch (SW41);
further comprising:
before the controlling of the first and second main switches (MSW41; MSW42) to be in the closed state,
maintaining the first and second main switches (MSW41; MSW42) in an opened state; and
for each of a plurality of battery control units (42-n) that respectively control an electrical connection between the plurality of battery modules (41) and the first and second main switches (MSW41; MSW42), detecting a second short-circuit accident between a corresponding battery control unit (42-n) of the plurality of battery control units (42-n) and the first and second main switches (MSW41; MSW42),
wherein the detecting the second short-circuit accident between the corresponding battery control unit (42-n) and the first and second main switches (MSW41; MSW42) includes:
controlling a fourth switch (SW42) connected between a negative terminal (B-) of a corresponding battery module (41) of the plurality of battery modules (41) and the second main switch (MSW42) to be in a closed state;
detecting a voltage between both ends of a third switch (SW41) in an opened state of the third switch (SW41) connected between a positive terminal (B+) of the corresponding battery module (41) and the first main switch (MSW41); and
detecting the second short-circuit accident between the corresponding battery control unit (42-n) and the first and second main switches (MSW41; MSW42) according to the detected voltage between both ends of the third switch (SW41).

10. The short-circuit detection method of claim 9, further comprising:
after controlling the first and second main switches (MSW41; MSW42) to be in the closed state, detecting an actual opening/closing state of the first and second main switches (MSW41; MSW42);
determining that the first main switch (MSW41) or the second main switch (MSW42) is in a failure state when the detected actual opening/closing state of the first main switch (MSW41) or the second main switch (MSW42) indicates an opened state; and
when the first main switch (MSW41) or the second main switch (MSW42) is in the failure state, controlling the first and second main switches (MSW41; MSW42) to be in an opened state.

11. The short-circuit detection method of claim 9 or 10, wherein
the detecting of the voltage between both ends of the first switch (SW41) and the detecting of the first short-circuit accident are performed when the first and second main switches (MSW41; MSW42) are in a normal state.

12. The short-circuit detection method of any of claims 9 to 11, further comprising:
when the first short-circuit accident is detected, controlling the first and second main switches (MSW41; MSW42) to be in an opened state; and
controlling the second switch (SW42) to be in an opened state.

13. The short-circuit detection method of claim 9, wherein
the detecting of the voltage between both ends of the first switch (SW41) and the detecting of the first short-circuit accident, are performed when the second short-circuit accident is not detected for all of the plurality of battery control units (42-n).

## Patentansprüche

1. Batteriesteuerungsvorrichtung, Folgendes umfassend:
eine erste Batteriesteuerungseinheit (12; 42), die zwischen eine externe Last (20; 50) und ein erstes Batteriemodul (11; 41) schaltbar ist und dafür konfiguriert ist, eine elektrische Verbindung zwischen der externen Last (20; 50) und dem ersten Batteriemodul (11; 41) zu steuern,
wobei die erste Batteriesteuerungseinheit (12; 42) Folgendes einschließt:
einen ersten Schalter (SW11; SW41), der elektrisch zwischen einen positiven Anschluss (B+) des ersten Batteriemoduls (11; 41) und die externe Last (20; 50) schaltbar ist,
einen zweiten Schalter (SW12; SW42), der elektrisch zwischen einen negativen Anschluss (B-) des ersten Batteriemoduls (11; 41) und die externe Last (20; 50) schaltbar ist, und
eine erste Steuerung (121; 421), die dafür konfiguriert ist, das Öffnen/Schließen des ersten und des zweiten Schalters (SW11; SW12; SW41; SW42) zu steuern, und
wobei die erste Steuerung (121; 421) dafür konfiguriert ist, einen Kurzschlussstörfall zwischen der externen Last (20; 50) und der ersten Batteriesteuerungseinheit (12; 42) gemäß einer Spannung zwischen beiden Enden des ersten Schalters (SW11; SW41) zu ermitteln, die ermittelt wird, wenn der zweite Schalter (SW12; SW42) in einem geschlossenen Zustand und der erste Schalter (SW11; SW41) in einem geöffneten Zustand ist;
ferner Folgendes umfassend:
eine Verbindungsvorrichtung (44), die zwischen die erste Batteriesteuerungseinheit (12; 42) und die externe Last (20; 50) schaltbar ist,
wobei die Verbindungsvorrichtung (44) Folgendes einschließt:
einen ersten Hauptschalter (MSW41), der elektrisch zwischen den ersten Schalter (SW11; SW41) und einen ersten Anschluss (T+) der externen Last (20; 50) schaltbar ist, und
einen zweiten Hauptschalter (MSW42), der elektrisch zwischen den zweiten Schalter und einen zweiten Anschluss (T-) der externen Last (20; 50) schaltbar ist;
wobei
die erste Steuerung (121; 421) dafür konfiguriert ist, wenn der erste Hauptschalter (MSW41), der zweite Hauptschalter (MSW42) und der erste Schalter (SW11; SW41) in einem geöffneten Zustand sind und der zweite Schalter (SW12; SW42) in einem geschlossenen Zustand ist, den Kurzschlussstörfall zwischen der ersten Batteriesteuerungseinheit (12; 42) und der Verbindungsvorrichtung (44) gemäß der Spannung zwischen beiden Enden des ersten Schalters (SW11; SW41) zu ermitteln; und
die erste Steuerung (121; 421) dafür konfiguriert ist, wenn der erste Hauptschalter (MSW41), der zweite Hauptschalter (MSW42) und der zweite Schalter (SW12; SW42) in einem geschlossenen Zustand sind und der erste Schalter (SW11; SW41) in einem geöffneten Zustand ist, einen Kurzschlussstörfall zwischen der Verbindungsvorrichtung (44) und der externen Last (20; 50) gemäß der Spannung zwischen beiden Enden des ersten Schalters (SW11; SW41) zu ermitteln.

2. Batteriesteuerungsvorrichtung nach Anspruch 1, ferner Folgendes umfassend:
eine zweite Batteriesteuerungseinheit (42-n), die zwischen ein zweites Batteriemodul (41) und die Verbindungsvorrichtung (44) schaltbar ist und dafür konfiguriert ist, eine elektrische Verbindung zwischen dem zweiten Batteriemodul (41) und dem ersten und dem zweiten Hauptschalter (MSW41; MSW42) zu steuern,
wobei die zweite Batteriesteuerungseinheit (42-n) Folgendes einschließt:
einen dritten Schalter (SW41), der elektrisch zwischen einen positiven Anschluss (B+) des zweiten Batteriemoduls (41) und den ersten Hauptschalter (MSW41) schaltbar ist,
einen vierten Schalter (SW42), der elektrisch zwischen einen negativen Anschluss (B-) des zweiten Batteriemoduls (41) und den zweiten Hauptschalter (MSW42) schaltbar ist, und
eine zweite Steuerung (421), die dafür konfiguriert ist, das Öffnen/Schließen des dritten und des vierten Schalters (SW41; SW42) zu steuern.

3. Batteriesteuerungsvorrichtung nach Anspruch 2, wobei
die zweite Steuerung (421) dafür konfiguriert ist, wenn der erste Hauptschalter (MSW41), der zweite Hauptschalter (MSW42) und der dritte Schalter (SW41) in einem geöffneten Zustand sind und der vierte Schalter (SW42) in einem geschlossenen Zustand ist, einen Kurzschlussstörfall zwischen der zweiten Batteriesteuerungseinheit (42-n) und der Verbindungsvorrichtung (44) gemäß einer Spannung zwischen beiden Enden des dritten Schalters (SW41) zu ermitteln.

4. Batteriesteuerungsvorrichtung nach Anspruch 3, wobei
die zweite Steuerung (421) dafür konfiguriert ist, den dritten und den vierten Schalter (SW41; SW42) so zu steuern, dass sie in einem geöffneten Zustand sind, während die erste Steuerung (421) einen Kurzschlussstörfall ermittelt, und
die erste Steuerung (421) dafür konfiguriert ist, den ersten und den zweiten Schalter (SW41; SW42) so zu steuern, dass sie in einem geöffneten Zustand sind, während die zweite Steuerung (421) einen Kurzschlussstörfall ermittelt.

5. Batteriesteuerungsvorrichtung nach Anspruch 1, ferner Folgendes umfassend:
eine Hauptsteuerung (43), die dafür konfiguriert ist, das Öffnen/Schließen des ersten und des zweiten Hauptschalters (MSW41; MSW42) zu steuern,
wobei die Hauptsteuerung (43) zu Folgendem konfiguriert ist:
in einem Zustand, in dem ein Steuersignal, welches das Umschalten in einen geschlossenen Zustand anweist, an den ersten und den zweiten Hauptschalter (SW41; SW42) ausgegeben wird, Ermitteln eines tatsächlichen Öffnungs-/Schließzustands des ersten und des zweiten Hauptschalters (SW41; SW42); und
Bestimmen, dass der erste Hauptschalter (MSW41) oder der zweite Hauptschalter (MSW42) in einem Fehlerzustand ist, wenn der tatsächliche Öffnungs-/Schließzustand des ersten Hauptschalters (MSW41) oder des zweiten Hauptschalters (MSW42) ein geöffneter Zustand ist.

6. Batteriesteuerungsvorrichtung nach Anspruch 5, wobei:
die erste Steuerung (421) dafür konfiguriert ist, den Kurzschlussstörfall gemäß der Spannung zwischen beiden Enden des ersten Schalters (SW41) zu ermitteln, wenn sowohl der erste als auch der zweite Hauptschalter (MSW41; MSW42) in einem normalen Zustand sind.

7. Batteriesteuerungsvorrichtung nach Anspruch 5 oder 6, wobei:
die Hauptsteuerung (43) dafür konfiguriert ist, den ersten und den zweiten Hauptschalter (MSW41; MSW42) zu öffnen, wenn mindestens einer des ersten und des zweiten Hauptschalters (MSW41; MSW42) in dem Fehlerzustand ist.

8. Batteriesteuerungsvorrichtung nach einem der Ansprüche 5 bis 7, wobei
die erste Steuerung (421) dafür konfiguriert ist, ein Zustandssignal, welches das Auftreten des Kurzschlussstörfalls meldet, an die Hauptsteuerung (43) zu übertragen, wenn der Kurzschlussstörfall ermittelt wird, und
die Hauptsteuerung (43) dafür konfiguriert ist, den ersten und den zweiten Hauptschalter (MSW41; MSW42) zu öffnen, wenn das Zustandssignal, welches das Auftreten des Kurzschlusses meldet, empfangen wird.

9. Kurzschlussermittlungsverfahren einer Batteriesteuerungsvorrichtung, Folgendes umfassend:
Steuern eines ersten Hauptschalters (MSW41), der elektrisch zwischen positive Anschlüsse (B+) einer Vielzahl von Batteriemodulen (41) und eine externe Last (50) geschaltet ist, und eines zweiten Hauptschalters (MSW42), der elektrisch zwischen negative Anschlüsse (B-) der Vielzahl von Batteriemodulen (41) und die externe Last (50) geschaltet ist, in einen geschlossenen Zustand;
in einer ersten Batteriesteuerungseinheit (42-n), die eine elektrische Verbindung zwischen einem ersten Batteriemodul (41) aus der Vielzahl von Batteriemodulen (41) und dem ersten und dem zweiten Hauptschalter (MSW41; MSW42) steuert, Steuern eines zweiten Schalters (SW42), der zwischen einen negativen Anschluss (B-) des ersten Batteriemoduls (41) und den zweiten Hauptschalter (MSW42) geschaltet ist, in einen geschlossenen Zustand;
Ermitteln einer Spannung zwischen beiden Enden eines ersten Schalters (SW41) in einem geöffneten Zustand des ersten Schalters (SW41), der zwischen einen positiven Anschluss (B+) des ersten Batteriemoduls (41) und den ersten Hauptschalter (MSW41) geschaltet ist; und
Ermitteln eines ersten Kurzschlussstörfalls zwischen der ersten Batteriesteuerungseinheit (42-n) und der externen Last (50) gemäß der ermittelten Spannung zwischen beiden Enden des ersten Schalters (SW41);
ferner Folgendes umfassend:
vor dem Steuern des ersten und des zweiten Hauptschalters (MSW41; MSW42), sodass sie im geschlossenen Zustand sind:
Halten des ersten und des zweiten Hauptschalters (MSW41; MSW42) in einem geöffneten Zustand; und
für jede einer Vielzahl von Batteriesteuerungseinheiten (42-n), die jeweils eine elektrische Verbindung zwischen der Vielzahl von Batteriemodulen (41) und dem ersten und dem zweiten Hauptschalter (MSW41; MSW42) steuern, Ermitteln eines zweiten Kurzschlussstörfalls zwischen einer entsprechenden Batteriesteuerungseinheit (42-n) der Vielzahl von Batteriesteuerungseinheiten (42-n) und dem ersten und dem zweiten Hauptschalter (MSW41; MSW42),
wobei das Ermitteln des zweiten Kurzschlussstörfalls zwischen der entsprechenden Batteriesteuerungseinheit (42-n) und dem ersten und dem zweiten Hauptschalter (MSW41; MSW42) Folgendes einschließt:
Steuern eines vierten Schalters (SW42), der zwischen einen negativen Anschluss (B-) eines entsprechenden Batteriemoduls (41) der Vielzahl von Batteriemodulen (41) und den zweiten Hauptschalter (MSW42) geschaltet ist, sodass er in einem geschlossenen Zustand ist;
Ermitteln einer Spannung zwischen beiden Enden eines dritten Schalters (SW41) in einem geöffneten Zustand des dritten Schalters (SW41), der zwischen einen positiven Anschluss (B+) des entsprechenden Batteriemoduls (41) und den ersten Hauptschalter (MSW41) geschaltet ist; und
Ermitteln des zweiten Kurzschlussstörfalls zwischen der entsprechenden Batteriesteuerungseinheit (42-n) und dem ersten und dem zweiten Hauptschalter (MSW41; MSW42) gemäß der ermittelten Spannung zwischen beiden Enden des dritten Schalters (SW41).

10. Kurzschlussermittlungsverfahren nach Anspruch 9, ferner Folgendes umfassend:
nach dem Steuern des ersten und des zweiten Hauptschalters (MSW41; MSW42) in den geschlossenen Zustand, Ermitteln eines tatsächlichen Öffnungs-/Schließzustands des ersten und des zweiten Hauptschalters (MSW41; MSW42);
Bestimmen, dass der erste Hauptschalter (MSW41) oder der zweite Hauptschalter (MSW42) in einem Fehlerzustand ist, wenn der erfasste tatsächliche Öffnungs-/Schließzustand des ersten Hauptschalters (MSW41) oder des zweiten Hauptschalters (MSW42) einen geöffneten Zustand angibt; und
wenn der erste Hauptschalter (MSW41) oder der zweite Hauptschalter (MSW42) in dem Fehlerzustand ist, Steuern des ersten und des zweiten Hauptschalters (MSW41; MSW42), sodass sie in einem geöffneten Zustand sind.

11. Kurzschlussermittlungsverfahren nach Anspruch 9 oder 10, wobei
das Ermitteln der Spannung zwischen beiden Enden des ersten Schalters (SW41) und das Ermitteln des ersten Kurzschlussstörfalls durchgeführt werden, wenn der erste und der zweite Hauptschalter (MSW41; MSW42) in einem normalen Zustand sind.

12. Kurzschlussermittlungsverfahren nach einem der Ansprüche 9 bis 11, ferner Folgendes umfassend:
wenn der erste Kurzschlussstörfall ermittelt wird, Steuern des ersten und des zweiten Hauptschalters (MSW41; MSW42), sodass sie in einem geöffneten Zustand sind; und
Steuern des zweiten Schalters (SW42), sodass er in einem geöffneten Zustand ist.

13. Kurzschlussermittlungsverfahren nach Anspruch 9, wobei
das Ermitteln der Spannung zwischen beiden Enden des ersten Schalters (SW41) und das Ermitteln des ersten Kurzschlussstörfalls durchgeführt werden, wenn der zweite Kurzschlussstörfall nicht für alle aus der Vielzahl von Batteriesteuerungseinheiten (42-n) ermittelt wird.

## Revendications

1. Dispositif de commande de batterie, comprenant :
une première unité de commande de batterie (12 ; 42) pouvant être connectée entre une charge externe (20 ; 50) et un premier module de batterie (11 ; 41) et configurée pour commander une connexion électrique entre la charge externe (20 ; 50) et le premier module de batterie (11 ; 41),
dans lequel la première unité de commande de batterie (12 ; 42) inclut :
un premier interrupteur (SW11 ; SW41) pouvant être connecté électriquement entre une borne positive (B+) du premier module de batterie (11 ; 41) et la charge externe (20 ; 50),
un deuxième interrupteur (SW12 ; SW42) pouvant être connecté électriquement entre une borne négative (B-) du premier module de batterie (11 ; 41) et la charge externe (20 ; 50), et
un premier dispositif de commande (121 ; 421) configuré pour commander l'ouverture/la fermeture des premier et deuxième interrupteurs (SW11 ; SW12 ; SW41 ; SW42), et
dans lequel le premier dispositif de commande (121 ; 421) est configuré pour détecter un accident de court-circuit entre la charge externe (20 ; 50) et la première unité de commande de batterie (12 ; 42), en fonction d'une tension entre les deux extrémités du premier interrupteur (SW11 ; SW41) détectée lorsque le deuxième interrupteur (SW12 ; SW42) est dans un état fermé et le premier interrupteur (SW11 ; SW41) est dans un état ouvert ;
comprenant en outre
un dispositif de connexion (44) pouvant être connecté entre la première unité de commande de batterie (12 ; 42) et la charge externe (20 ; 50),
dans lequel le dispositif de connexion (44) inclut
un premier interrupteur principal (MSW41) pouvant être connecté électriquement entre le premier interrupteur (SW11 ; SW41) et une première borne (T+) de la charge externe (20 ; 50), et
un deuxième interrupteur principal (MSW42) pouvant être connecté électriquement entre le deuxième interrupteur et une deuxième borne (T-) de la charge externe (20 ; 50) ;
dans lequel
lorsque le premier interrupteur principal (MSW41), le deuxième interrupteur principal (MSW42) et le premier interrupteur (SW11 ; SW41) sont dans un état ouvert et le deuxième interrupteur (SW12 ; SW42) est dans un état fermé, le premier dispositif de commande (121 ; 421) est configuré pour détecter l'accident de court-circuit entre la première unité de commande de batterie (12 ; 42) et le dispositif de connexion (44) en fonction de la tension entre les deux extrémités du premier interrupteur (SW11 ; SW41) ; et
lorsque le premier interrupteur principal (MSW41), le deuxième interrupteur principal (MSW42) et le deuxième interrupteur (SW12 ; SW42) sont dans un état fermé et le premier interrupteur (SW11 ; SW41) est dans un état ouvert, le premier dispositif de commande (121 ; 421) est configuré pour détecter un accident de court-circuit entre le dispositif de connexion (44) et la charge externe (20 ; 50) en fonction de la tension entre les deux extrémités du premier interrupteur (SW11 ; SW41).

2. Dispositif de commande de batterie selon la revendication 1, comprenant en outre
une deuxième unité de commande de batterie (42-n) pouvant être connectée entre un deuxième module de batterie (41) et le dispositif de connexion (44) et configurée pour commander une connexion électrique entre le deuxième module de batterie (41) et les premier et deuxième interrupteurs principaux (MSW41 ; MSW42),
dans lequel la deuxième unité de commande de batterie (42-n) inclut :
un troisième interrupteur (SW41) pouvant être connecté électriquement entre une borne positive (B+) du deuxième module de batterie (41) et le premier interrupteur principal (MSW41),
un quatrième interrupteur (SW42) pouvant être connecté électriquement entre une borne négative (B-) du deuxième module de batterie (41) et le deuxième interrupteur principal (MSW42), et
un deuxième dispositif de commande (421) configuré pour commander l'ouverture/la fermeture des troisième et quatrième interrupteurs (SW41 ; SW42).

3. Dispositif de commande de batterie selon la revendication 2, dans lequel
lorsque le premier interrupteur principal (MSW41), le deuxième interrupteur principal (MSW42) et le troisième interrupteur (SW41) sont dans un état ouvert et le quatrième interrupteur (SW42) est dans un état fermé, le deuxième dispositif de commande (421) est configuré pour détecter un accident de court-circuit entre la deuxième unité de commande de batterie (42-n) et le dispositif de connexion (44) en fonction d'une tension entre les deux extrémités du troisième interrupteur (SW41).

4. Dispositif de commande de batterie selon la revendication 3, dans lequel
le deuxième dispositif de commande (421) est configuré pour commander les troisième et quatrième interrupteurs (SW41 ; SW42) pour qu'ils soient dans un état ouvert pendant que le premier dispositif de commande (421) détecte un accident de court-circuit, et
le premier dispositif de commande (421) est configuré pour commander les premier et deuxième interrupteurs (SW41 ; SW42) pour qu'ils soient dans un état ouvert pendant que le deuxième dispositif de commande (421) détecte un accident de court-circuit.

5. Dispositif de commande de batterie selon la revendication 1, comprenant en outre
un dispositif de commande principal (43) configuré pour commander l'ouverture/la fermeture des premier et deuxième interrupteurs principaux (MSW41 ; MSW42),
dans lequel le dispositif de commande principal (43) est configuré pour :
détecter un état réel d'ouverture/fermeture des premier et deuxième interrupteurs principaux (SW41 ; SW42) dans un état dans lequel un signal de commande ordonnant la commutation à un état fermé est émis vers les premier et deuxième interrupteurs principaux (SW41 ; SW42) ; et
déterminer que le premier interrupteur principal (MSW41) ou le deuxième interrupteur principal (MSW42) est dans un état de défaillance lorsque l'état réel d'ouverture/fermeture du premier interrupteur principal (MSW41) ou du deuxième interrupteur principal (MSW42) est un état ouvert.

6. Dispositif de commande de batterie selon la revendication 5, dans lequel
le premier dispositif de commande (421) est configuré pour détecter l'accident de court-circuit en fonction de la tension entre les deux extrémités du premier interrupteur (SW41) lorsque les premier et deuxième interrupteurs principaux (MSW41 ; MSW42) sont dans un état normal.

7. Dispositif de commande de batterie selon la revendication 5 ou 6, dans lequel
le dispositif de commande principal (43) est configuré pour ouvrir les premier et deuxième interrupteurs principaux (MSW41 ; MSW42) lorsqu'au moins un des premier et deuxième interrupteurs principaux (MSW41 ; MSW42) est dans l'état de défaillance.

8. Dispositif de commande de batterie selon l'une quelconque des revendications 5 à 7, dans lequel
le premier dispositif de commande (421) est configuré pour transmettre un signal d'état notifiant l'occurrence de l'accident de court-circuit au dispositif de commande principal (43) lorsque l'accident de court-circuit est détecté, et
le dispositif de commande principal (43) est configuré pour ouvrir les premier et deuxième interrupteurs principaux (MSW41 ; MSW42) lorsque le signal d'état notifiant l'occurrence du court-circuit est reçu.

9. Procédé de détection des courts-circuits d'un dispositif de commande de batterie, comprenant les étapes consistant à :
commander un premier interrupteur principal (MSW41) connecté électriquement entre des bornes positives (B+) d'une pluralité de modules de batterie (41) et une charge externe (50) et un deuxième interrupteur principal (MSW42) connecté électriquement entre des bornes négatives (B-) de la pluralité de modules de batterie (41) et la charge externe (50) pour qu'il soit dans un état fermé ;
dans une première unité de commande de batterie (42-n) commandant une connexion électrique entre un premier module de batterie (41) parmi la pluralité de modules de batterie (41) et les premier et deuxième interrupteurs principaux (MSW41 ; MSW42), commander un deuxième interrupteur (SW42) connecté entre une borne négative (B-) du premier module de batterie (41) et le deuxième interrupteur principal (MSW42) pour qu'il soit dans un état fermé ;
détecter une tension entre les deux extrémités d'un premier interrupteur (SW41) dans un état ouvert du premier interrupteur (SW41) connecté entre une borne positive (B+) du premier module de batterie (41) et le premier interrupteur principal (MSW41) ; et
détecter un premier accident de court-circuit entre la première unité de commande de batterie (42-n) et la charge externe (50) en fonction de la tension détectée entre les deux extrémités du premier interrupteur (SW41) ;
comprenant en outre les étapes consistant à :
avant la commande des premier et deuxième interrupteurs principaux (MSW41 ; MSW42) pour qu'ils soient dans l'état fermé,
maintenir les premier et deuxième interrupteurs principaux (MSW41 ; MSW42) dans un état ouvert ; et
pour chacune d'une pluralité d'unités de commande de batterie (42-n) qui commandent respectivement une connexion électrique entre la pluralité de modules de batterie (41) et les premier et deuxième interrupteurs principaux (MSW41 ; MSW42), détecter un deuxième accident de court-circuit entre une unité de commande de batterie (42-n) correspondante de la pluralité d'unités de commande de batterie (42-n) et les premier et deuxième interrupteurs principaux (MSW41 ; MSW42),
dans lequel la détection du deuxième accident de court-circuit entre l'unité de commande de batterie (42-n) correspondante et les premier et deuxième interrupteurs principaux (MSW41 ; MSW42) inclut les étapes consistant à :
commander un quatrième interrupteur (SW42) connecté entre une borne négative (B-) d'un module de batterie correspondant (41) de la pluralité de modules de batterie (41) et le deuxième interrupteur principal (MSW42) pour qu'il soit dans un état fermé ;
détecter une tension entre les deux extrémités d'un troisième interrupteur (SW41) dans un état ouvert du troisième interrupteur (SW41) connecté entre une borne positive (B+) du module de batterie (41) correspondant et le premier interrupteur principal (MSW41) ; et
détecter le deuxième accident de court-circuit entre l'unité de commande de batterie (42-n) correspondante et les premier et deuxième interrupteurs principaux (MSW41 ; MSW42) en fonction de la tension détectée entre les deux extrémités du troisième interrupteur (SW41).

10. Procédé de détection des courts-circuits selon la revendication 9, comprenant en outre les étapes consistant à :
après avoir commandé les premier et deuxième interrupteurs principaux (MSW41 ; MSW42) pour qu'ils soient dans l'état fermé, détecter un état réel d'ouverture/fermeture des premier et deuxième interrupteurs principaux (MSW41 ; MSW42) ;
déterminer que le premier interrupteur principal (MSW41) ou le deuxième interrupteur principal (MSW42) est dans un état de défaillance lorsque l'état réel d'ouverture/fermeture détecté du premier interrupteur principal (MSW41) ou du deuxième interrupteur principal (MSW42) indique un état ouvert ; et
lorsque le premier interrupteur principal (MSW41) ou le deuxième interrupteur principal (MSW42) est dans l'état de défaillance, commander les premier et deuxième interrupteurs principaux (MSW41 ; MSW42) pour qu'ils soient dans un état ouvert.

11. Procédé de détection des courts-circuits selon la revendication 9 ou 10, dans lequel
la détection de la tension entre les deux extrémités du premier interrupteur (SW41) et la détection du premier accident de court-circuit sont effectuées lorsque les premier et deuxième interrupteurs principaux (MSW41 ; MSW42) sont dans un état normal.

12. Procédé de détection des courts-circuits selon l'une quelconque des revendications 9 à 11, comprenant en outre les étapes consistant à :
lorsque le premier accident de court-circuit est détecté, commander les premier et deuxième interrupteurs principaux (MSW41 ; MSW42) pour qu'ils soient dans un état ouvert ; et
commander le deuxième interrupteur (SW42) pour qu'il soit dans un état ouvert.

13. Procédé de détection des courts-circuits selon la revendication 9, dans lequel
la détection de la tension entre les deux extrémités du premier interrupteur (SW41) et la détection du premier accident de court-circuit sont effectuées lorsque le deuxième accident de court-circuit n'est pas détecté pour l'ensemble de la pluralité d'unités de commande de batterie (42-n).
